# EUROPÄISCHE PATENTSCHRIFT

(11) **EP 1 328 970 B1**
(45) Veröffentlichungstag und Bekanntmachung des Hinweises auf die Patenterteilung: **20.12.2006**
(21) Anmeldenummer: 01988948.4
(22) Anmeldetag: 17.10.2001
(51) Int. Cl.: H01L 21/336, H01L 21/8234

(54) **VERFAHREN ZUR HERSTELLUNG EINES DMOS-TRANSISTORS**
METHOD FOR PRODUCING A DMOS TRANSISTOR
PROCEDE DE FABRICATION D'UN TRANSISTOR DMOS

(30) Priorität: 27.10.2000 DE 10053428
(43) Veröffentlichungstag der Anmeldung: 23.07.2003
(73) Patentinhaber: Infineon Technologies AG, 81669 München (DE)
(72) Erfinder: MUELLER, Karlheinz, 84149 Velden (DE); WAGNER, Cajetan, 01099 Dresden (DE); ROESCHLAU, Klaus, 81545 Muenchen (DE)
(74) Vertreter: Ginzel, Christian
(86) Internationale Anmeldenummer: PCT/EP2001/012035
(87) Internationale Veröffentlichungsnummer: WO 2002/035600

(56) Entgegenhaltungen:
- PATENT ABSTRACTS OF JAPAN vol. 015, no. 419 (E-1126), 24. Oktober 1991 (1991-10-24) & JP 03 175678 A (SHARP CORP), 30. Juli 1991 (1991-07-30)

## Beschreibung

Die vorliegende Erfindung betrifft ein Verfahren zur Herstellung eines DMOS-Transistors, insbesondere ein Verfahren zur Herstellung eines DMOS-Transistors, der mit einer CMOS-Logik in einem Halbleiterbauelement integriert ist.

Bei vielen Anwendungen von modernen elektronischen Produkten stellt sich das Problem, daß neben der reinen Verarbeitung von Informationen das elektronische Produkt auch in irgendeiner Form auf seine Umgebung einwirken muß. Derartige Anwendungen umfassen ein sehr weites Produktspektrum. Als ein Beispiel sei hierfür das Steuerungssytem eines Airbags genannt, das einerseits die Meßsignale eines Beschleunigungssensors auswertet und das dann andererseits, wenn es zu einem Unfall kommt, den Airbag auslöst. Ein weiteres Beispiel ist ein intelligentes Ladegerät zum Aufladen von Batterien.

Aus Kostengründen ist es vorteilhaft, wenn all diese unterschiedlichen Funktionen in ein einziges Halbleiterprodukt intergriert werden können. Bei der Herstellung von derartigen "Smart-Power" Produkten werden jedoch hohe Anforderungen an den verwendeten Herstellungsprozeß gestellt. So müssen beispielsweise verschiedenartige Bauelementtypen, wie CMOS-Transistoren, DMOS-Leistungstransistoren und BipolarTransistoren, mit hoher Packungsdichte auf einem Chip integriert werden. Dabei sollte die Integration in einer Weise erfolgen, daß die einzelnen Bauelementtypen möglichst ideale Bauelementparameter aufweisen. Gleichzeitig sollte der Herstellungsprozeß jedoch möglichst wenige Prozeßschritte, insbesondere wenige Maskenebenen aufweisen.

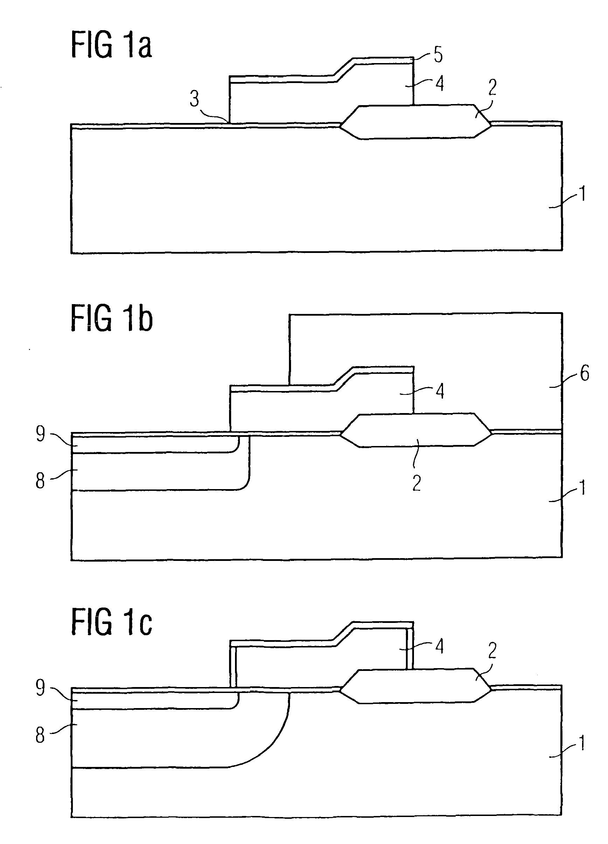

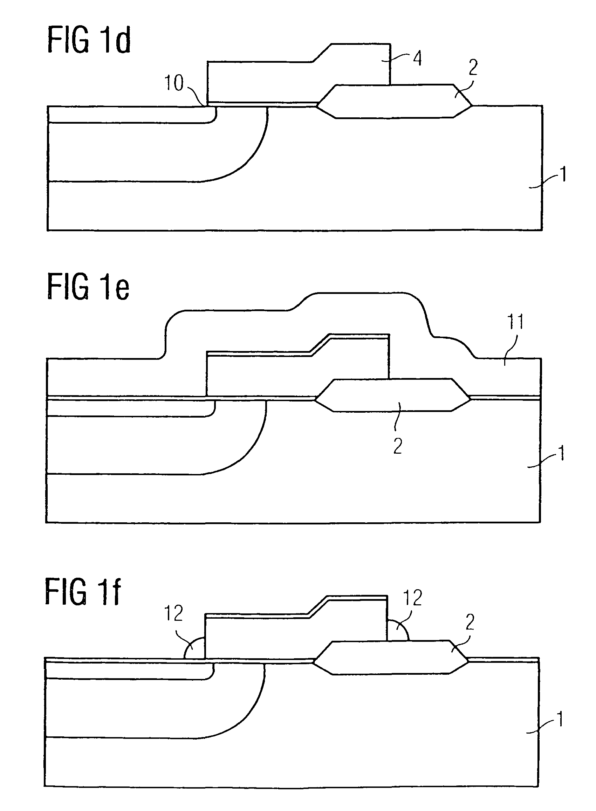

Bei der Integration von einem oder mehreren DMOS-Leistungstransistoren und einer CMOS-Logik ist es üblich, zwei unterschiedliche Gateoxid/Gatepoly Komplexe zu verwenden. Auf diese weise können die Deviceparameter des DMOS-Transistors und die Deviceparameter der CMOS-Transistoren entsprechend den jeweiligen Anforderungen weitgehend unabhängig von einander eingestellt werden. Der typische Prozeßablauf bei der Integration von zwei Gateoxid/Gatepoly Komplexen ist anhand von schematischen Querschnittsbildern im Bereich des DMOS-Transistors in den Fig. 1a bis 1f skizziert.

Zur Herstellung des DMOS-Transistors wird ein Halbleitersubstrat 1 bereitgestellt, auf dem bereits die Isolation zwischen den einzelnen Transistoren 2 und das sogenannte "Gate-Oxid" 3 erzeugt wurden. Anschließend wird eine Polysiliziumschicht 4 und darauf eine Isolationsschicht 5 abgeschieden. Nachfolgend werden die Polysiliziumschicht 4 und die Isolationsschicht 5 mittels einer Photolithographie zu einem sogenannten DMOS-Gatestack strukturiert (Fig. 1a).

Anschließend wird ein Fotolack 6 aufgebracht, welcher mit einer zweiten Photolithographieebene strukturiert wird. Der strukturierte Fotolack 6 bildet eine Maske, mit deren Hilfe die Dotierstoffe für Body 8 und Source 9 des DMOS-Transistors in das Sourcegebiet des DMOS-Transistors implantiert werden (Fig. 1b).

Durch eine Wärmebehandlung diffundieren die implantierten Dotierstoffe aus und bilden Body 8 und Source 9 des DMOS-Transistors (Fig. 1c). Dabei entstehen wegen der amorphisierenden Sourceimplantation häufig Kristalldefekte. Mit der Bildung von Body 8 und Source 9 des DMOS-Transistors ist bis auf die Anschlußimplantationen die Herstellung des DMOS-Transistors im wesentlichen abgeschlossen. Es folgen jedoch weitere Prozeßschritte, welche der Herstellung der CMOS-Transistoren (nicht gezeigt) dienen und welche natürlich auch Auswirkungen auf den im wesentlichen fertigen DMOS-Transistor haben.

Es folgt ein Freiätzen der aktiven Gebiete. Im Bereich des DMOS-Transistors führt dies zu einer Freiätzung der Source des DMOS-Transistors. Dieses Freiätzen der aktiven Gebiete dient im Bereich der CMOS-Transistoren dazu, die Herstellung des Gateoxids für die CMOS-Transistoren vorzubereiten. Bei diesem Ätzschritt kommt es zu einer Unterätzung 10 des DMOS-Gateoxids unterhalb des DMOS-Gatestacks (Fig. ld).

Anschließend erfolgt die Herstellung des Gateoxids für die CMOS-Transistoren und bei dieser CMOS-Gateoxidation wird im Bereich des DMOS-Transistors die freiliegende DMOS-Gatepolyflanke oxidiert und im Bereich der Unterätzung 10, am Übergang zur Source 9 erhöht sich die Gateoxiddicke des DMOS-Transistors ("Vogelschnabel"). Dadurch wird die Schwellwertspannung unkontrollierbar beeinflußt, was ihre Streuung stark erhöht. Es folgt die Abscheidung einer weiteren Polysiliziumschicht 11, die im Bereich der CMOS-Transistoren zur Herstellung der CMOS-Gatestacks dient (Fig. le).

Bei der nachfolgenden Strukturierung des CMOS-Gateelektrode bleiben sogenannte Spacer 12 an den Flanken der DMOS-Gateelektrode (Fig. 1f) stehen, die sich wegen des Polyüberhanges nicht vollständig entfernen lassen. Diese hochdotierten Polysilizium-Spacer 12 bringen eine Reihe von negativen Auswirkungen in Hinsicht auf die Streuung der Schwellwertspannung des DMOS-Transistors und die erzielbare Ausbeute mit sich.

Ein weiteres Verfahren zur Herstellung eines DMOS-Transistors ist aus dem Dokument Patent Abstracts of Japan, Bd. 15, Nr. 419 (E-1126), 24 Oktober 1991, & JP-A-3175678 bekannt.

Man erkennt, daß im Stand der Technik die Herstellung der CMOS-Transistoren zu einer Reihe von nachteiligen Auswirkungen auf die bereits erzeugten DMOS-Transistoren führt, die die Deviceparameter des DMOS-Transistors deutlich verschlechtern oder zum Ausfall des gesamten integrieten Bauelements führen können.

Es ist daher die Aufgabe der vorliegenden Erfindung, ein Verfahren zur Herstellung einer DMOS-Transistorstruktur bereitzustellen, das die genannten Schwierigkeiten vermindert bzw. ganz vermeidet.

Diese Aufgabe wird von dem Verfahren gemäß Patentanspruch 1 gelöst. Weitere vorteilhafte Ausführungsformen, Ausgestaltungen und Aspekte der vorliegenden Erfindung ergeben sich aus den Unteransprüchen, der Beschreibung und den beiliegenden Zeichnungen.

Erfindungsgemäß wird ein Verfahren zur Herstellung einer DMOS-Transistorstruktur bereitgestellt, das die folgenden Schritte umfaßt:
a) ein Halbleitersubstrat mit einem Gateoxid wird bereitgestellt,
b) auf das Gateoxid wird eine leitende Schicht aufgebracht,
c) die leitende Schicht wird strukturiert, wobei im wesentlichen nur die Teile der leitenden Schicht, die über dem Source-Gebiet angeordnet sind, entfernt werden,
d) das Body- und das Source-Gebiet werden erzeugt,
e) zumindest eine Schutzschicht wird aufgebracht
f) die Schutzschicht und die leitende Schicht werden strukturiert, so daß die Gateelektrode erzeugt wird, und
g) die Schutzschicht wird zumindest über dem Source-Gebiet entfernt.

Die Erfindung besitzt den Vorteil, daß durch die Verwendung einer Schutzschicht die bereits im wesentlichen fertiggestellte DMOS-Transitorstruktur vor den negativen Auswirkungen von weiteren Prozeßschritten geschützt ist. Erfindungsgemäß wird die DMOS-Gateelektrode nicht, wie im Stand der Technik üblich, mit einem einzigen Lithographieschritt strukturiert, sondern die Strukturierung der DMOS-Gateelektrode wird auf zwei Lithographieschritte aufgeteilt. In einem ersten Lithographieschritt wird im wesentlichen nur das Sourcegebiet der DMOS-Transitorstruktur geöffnet. Die noch vorhandene Elektrodenschicht kann somit als Maske für die nachfolgende Erzeugung des Body-Gebiets eingesetzt werden.

Nach der Durchführung der für die DMOS-Transistorstruktur wesentlichen Prozeßschritte zur Herstellung des Body- und Sourcegebietes wird dann eine Schutzschicht aufgebracht, die bei der endgültigen Strukturierung der DMOS-Gateelektrode durch einen weiteren Lithographieschritt auf dem Sourcegebiet erhalten bleibt und dieses bei der weiteren Prozessierung, beispielsweise zur Herstellung von CMOS-Transistoren oder Bipolartransistoren, schützt. Trotz der Aufteilung der DMOS-Gatestrukturierung auf zwei Photolithographieebenen kann das erfindungsgemäße Verfahren ohne zusätzlichen Lithographieschritt realisiert werden, da die im Stand der Technik erforderliche Maske für die Bodyimplantation entfällt.

Bevorzugt wird als leitende Schicht eine Polysiliziumschicht verwendet. Weiterhin ist es bevorzugt, wenn die Schutzschicht eine Siliziumoxid-, Siliziumnitrid-, Siliziumoxidschicht umfaßt. Dabei ist es insbesondere bevorzugt, wenn als Siliziumoxidschicht eine TEOS-Schicht verwendet wird.

Gemäß einer bevorzugten Ausführungsform wird der DMOS-Transistor mit CMOS-Transistoren in einem Halbleiterbauelement integriert. In diesem Fall dient die Schutzschicht insbesondere dazu, die bereits im wesentlichen fertiggestellte DMOS-Transitorstruktur vor den negativen Auswirkungen von weiteren Prozeßschritten zur Herstellung des Gateoxids/der Gateelektrode für die CMOS-Transistoren zu schützen.

Dabei ist es insbesondere bevorzugt, wenn das Gateoxid für die CMOS-Transistoren zwischen Schritt f) und Schritt g) erzeugt wird. Weiterhin ist es bevorzugt, wenn die Gateelektroden der CMOS-Transistoren zwischen Schritt f) und Schritt g) erzeugt werden. Gemäß einer weiteren bevorzugten Ausführungsform wird eine Ätzung zur Entfernung der Reste der Gateelektroden für die CMOS-Transistoren über dem Source-Gebiet durchgeführt.

Die Erfindung wird nachfolgend anhand von Figuren der Zeichnung näher dargestellt. Es zeigen:
- Fig. 1a bis 1f: eine schematische Darstellungen eines Verfahrens nach dem Stand der Technik,
- Fig. 2a bis 2f: eine schematische Darstellungen eines erfindungsgemäßen Verfahrens, und

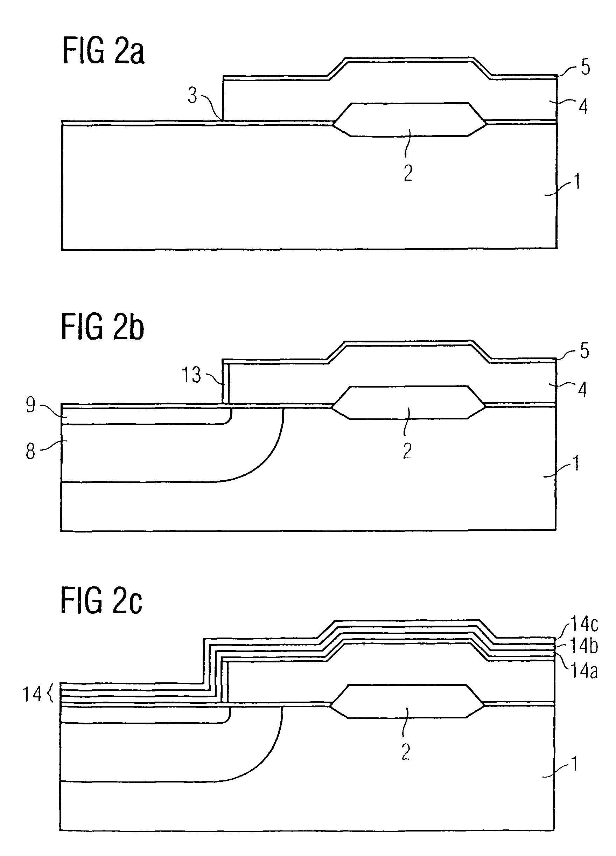

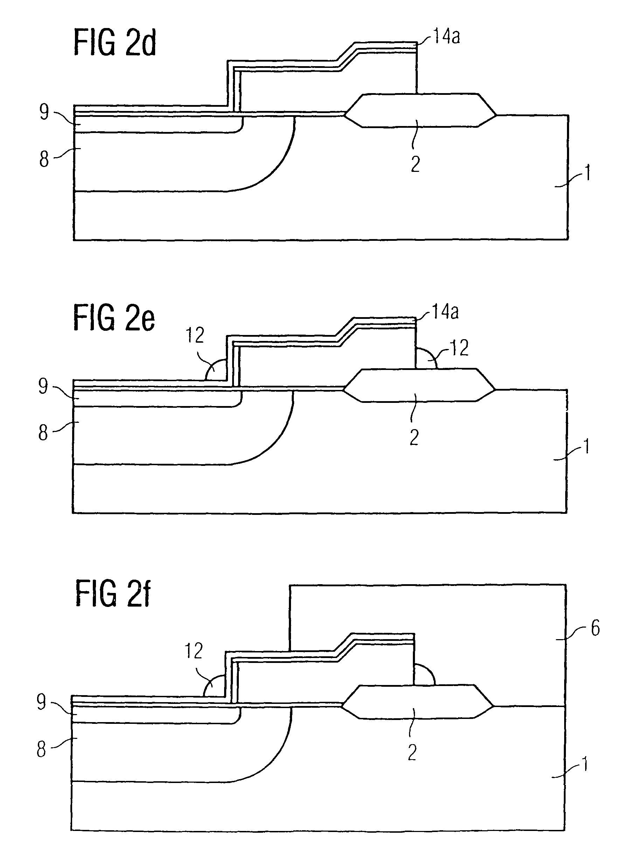

Die Figuren 2a bis 2f zeigen eine schematische Darstellungen eines erfindungsgemäßen Verfahrens zur Herstellung einer DMOS-Transistorstruktur. Zur Herstellung der DMOS-Transistorstruktur wird ein Halbleitersubstrat 1 bereitgestellt, auf dem bereits die Isolation 2 zwischen den einzelnen Transistoren und das "Gate-Oxid" 3 erzeugt wurden. Weiterhin wurden bereits alle Wannengebiete, vergrabenen Gebiete sowie Tiefdiffusion, welche zur vollständige Herstellung eines DMOS-Transistors sowie von CMOS-Transistoren notwendig sind, erzeugt. Anschließend wird eine leitende Schicht, bevorzugt eine Polysiliziumschicht 4 und darauf eine Isolationsschicht 5 abgeschieden. Nachfolgend werden die Polysiliziumschicht 4 und die Isolationsschicht 5 mittels einer Photolithographie strukturiert, so daß die Polysiliziumschicht 4 im wesentlichen nur im Sourcegebiet geöffnet wird (Fig. 2a). Alle übrigen Gebiete, insbesondere die Gebiete, in denen später CMOS-Transistoren erzeugt werden sollen, bleiben von der Polysiliziumschicht 4 bedeckt.

Anschließend wird eine Dotierstoffimplantation zur Herstellung des Body- sowie des Sourcegebiets durchgeführt. Die Implantationen von Body 8 und Source 9 werden durch die strukturierte Polysiliziumschicht 4 maskiert. Dabei wird zuerst der Dotierstoff für das Bodygebiet implantiert und durch eine Wärmebehandlung in das Halbleitersubstrat 1 eingetrieben. Anschließend wird der Dotierstoff für das Sourcegebiet implantiert und durch eine zweite Wärmebehandlung in das Halbleitersubstrat 1 eingetrieben. Daraus ergibt sich gegenüber den herkömmlichen Verfahren der Vorteil, daß die Sourceimplantation ohne Zusatzaufwand nach der Bodydiffusion durchgeführt werden kann. Dies reduziert die Kristalldefektdichte und erleichtert die Optimierung der Sourcedotierung. Bevorzugt findet zu Beginn der ersten Wärmebehandlung (Ofenschritt) eine Oxidation 13 zum Versiegeln der offenen Polysiliziumflanke statt (Fig. 2b).

Danach wird das Sourcegebiet und die verbliebenen Polysiliziumbereiche mittels einer Schutzschicht 14 abgedeckt (Abb. 2c). Im vorliegenden Beispiel umfaßt die Schutzschicht 14 drei Einzelschichten, nämlich eine Siliziumoxidschicht 14a, eine Siliziumnitridschicht 14b sowie eine weitere Siliziumoxidschicht 14c. Alle drei Schichten werden bevorzugt mit Hilfe von CVD-Verfahren erzeugt. Insbesondere ist bevorzugt, wenn die beiden Siliziumoxidschichten 14a, 14c mittels eines TEOS-Verfahrens erzeugt werden.

Nachfolgend wird der DMOS-Gatestack mit einer zweiten Photolithographieebene vollständig strukturiert. Dabei wird die leitende Schicht 4 auch im Bereich aller anderen Bauelemente, insbesondere im Bereich der noch zu erzeugenden CMOS-Transistoren (nicht gezeigt) entfernt. Dabei kann die Schutzschicht 14 als Hartmaske für die Ätzung der leitenden Schicht 4 verwendet werden.

Es folgt ein Freiätzen der aktiven Gebiete. Bei diesem Freiätzen der Siliziumoberfläche vor der Gateoxidation für die CMOS-Transistoren wird die obere TEOS-Schicht entfernt. Eine Unterätzung der DMOS-Gateelektrode, wie sie an diesem Punkt im Prozeßablauf nach dem Stand der Technik auftritt, wird jedoch durch die Siliziumnitridschicht verhindert. Dementsprechend wird im weiteren Verlauf auch die Bildung eines sogenannten "Vogelschnabels" an der Kante der Gateelektrode wirksam verhindert. Dies ist ein weiterer wichtiger Vorteil des erfindungsgemäßen Verfahren gegenüber den Verfahren nach dem Stand der Technik.

Anschließend wird die Nitridschicht beispielsweise mittels Naßätzung entfernt. Die sich daraus ergebende Situation ist in Fig. 2d gezeigt. Vor der Bildung des Gateoxids für die CMOS-Transistoren und die Abscheidung einer weiteren leitenden Schicht, insbesondere einer weiteren Polysiliziumschicht, ist somit das DMOS-Sourcegebiet noch mit der TEOS-Schicht 14a abgedeckt. Daraus ergibt sich der Vorteil, daß eine weitere Aufoxidation und damit die Bildung eines sogenannten "Vogelschnabels" unter der DMOS-Gateelektrode im Sourcebereich weitgehend vermieden wird (Fig. 2e).

Bei der Strukturierung der leitenden Schicht zur Bildung der Gateelektroden für die CMOS-Transistoren bleiben in der Regel Reste der leitenden Schicht neben der DMOS-Gateelektrode auf dem Sourcegebiet zurück. Diese Polysiliziumreste 12 im Sourcebereich sind durch die verbliebene Schutzschicht 14 (TEOS-Schicht 14a) jetzt ausreichend vom Sourcegebiet und der DMOS-Gateelektrode separiert und liegen vor allem nicht mehr unter einem überhängendem Bereich der DMOS-Gateelektrode.

Optional können diese Polysiliziumreste 12 mittels eines zusätzlichen Lithographieschrittes auch leicht entfernt werden. Anschließend werden die Anschlüsse für den DMOS-Transistor erzeugt. Dazu wird, wie allgemein üblich, über der Source 9 ein Spacer (nicht gezeigt) erzeugt und eine Anschlußimplantation durchgeführt. Bei der Erzeugung des Spacers wird die Siliziumoxidschicht 14a über der Source 9 entfernt, so daß die Source 9 in weiteren Prozeßschritten von einer leitenden Schicht (nicht gezeigt) kontaktiert werden kann.

## Patentansprüche

1. Verfahren zur Herstellung einer DMOS-Transistorstruktur, mit den Schritten:
a) ein Halbleitersubstrat (1) mit einem Gateoxid (3) wird bereitgestellt,
b) auf das Gateoxid (3) wird eine leitende Schicht (4) aufgebracht,
c) die leitende Schicht (4) wird strukturiert, wobei im wesentlichen nur die Teile der leitenden Schicht (4), die über dem späteren Source-Gebiet (9) angeordnet sind, entfernt werden,
d) das Body-Gebiet (8) und das Source-Gebiet (9) werden erzeugt,
e) zumindest eine Schutzschicht (14) wird aufgebracht
f) die Schutzschicht (14) und die leitenden Schicht (4) werden strukturiert, so daß die Gateelektrode erzeugt wird, und
g) die Schutzschicht (14) wird zumindest über dem Source-Gebiet (9) entfernt.

2. Verfahren nach Anspruch 1,
**dadurch gekennzeichnet, daß**
als leitende Schicht (4) eine Polysiliziumschicht verwendet wird.

3. Verfahren nach Anspruch 1 oder 2,
**dadurch gekennzeichnet, daß**
die Schutzschicht (14) eine Siliziumoxid- (14a), Siliziumnitrid- (14b), Siliziumoxidschicht (14c) umfaßt.

4. Verfahren nach nach Anspruch 2,
**dadurch gekennzeichnet, daß**
als Siliziumoxidschicht (14a, 14c) eine TEOS-Schicht verwendet wird.

5. Verfahren nach einem der Ansprüch 1 bis 4,
**dadurch gekennzeichnet, daß**
der DMOS-Transistor mit CMOS-Transistoren in einem Halbleiterbauelement integriert wird.

6. Verfahren nach Anspruch 5,
**dadurch gekennzeichnet, daß**
das Gateoxid für die CMOS-Transistoren zwischen Schritt f) und Schritt g) erzeugt wird.

7. Verfahren nach einem der Ansprüche 5 oder 6,
**dadurch gekennzeichnet, daß**
die Gateelektroden der CMOS-Transistoren zwischen Schritt f) und Schritt g) erzeugt werden.

8. Verfahren nach einem der Ansprüch 5 bis 7,
**dadurch gekennzeichnet, daß**
eine Ätzung zur Entfernung der Reste (12) der Gateelektroden für die CMOS-Transistoren über dem Source-Gebiet (9) durchgeführt wird.

## Claims

1. Method for the fabrication of a DMOS transistor structure, comprising the following steps:
a) a semiconductor substrate (1) with a gate oxide (3) is provided,
b) a conductive layer (4) is applied to the gate oxide (3),
c) the conductive layer (4) is patterned, with substantially only those parts of the conductive layer (4) which are arranged above the subsequent source region (9) being removed,
d) the body region (8) and the source region (9) are produced,
e) at least one protective layer (14) is applied,
f) the protective layer (14) and the conductive layer (4) are patterned, so that the gate electrode is produced, and
g) the protective layer (14) is removed at least above the source region (9).

2. Method according to Claim 1, **characterized in that** a polysilicon layer is used as conductive layer (4).

3. Method according to Claim 1 or 2, **characterized in that** the protective layer (14) comprises a silicon oxide layer (14a), a silicon nitride layer (14b), a silicon oxide layer (14c).

4. Method according to Claim 2, **characterized in that** the silicon oxide layer (14a, 14c) used is a TEOS layer.

5. Method according to one of Claims 1 to 4, **characterized in that** the DMOS transistor is integrated with CMOS transistors in a semiconductor component.

6. Method according to Claim 5, **characterized in that** the gate oxide for the CMOS transistors is produced between step f) and step g).

7. Method according to one of Claims 5 or 6, **characterized in that** the gate electrodes of the CMOS transistors are produced between step f) and step g).

8. Method according to one of Claims 5 to 7, **characterized in that** etching is carried out in order to remove the residues (12) of the gate electrodes for the CMOS transistors above the source region (9).

## Revendications

1. Procédé de production d'une structure de transistor DMOS comprenant les stades dans lesquels :
a) on se procure un substrat (1) semiconducteur ayant un oxyde (3) de grille,
b) on dépose une couche (4) conductrice sur l'oxyde (3) de grille,
c) on structure la couche (4) conductrice en n'éliminant sensiblement que les parties de la couche (4) conductrice qui sont au-dessus de la zone (9) de source ultérieure,
d) on produit la zone (8) de body et la zone (9) de source,
e) on dépose au moins une couche (14) de protection,
f) on structure la couche (14) de protection et la couche (4) conductrice de manière à produire l'électrode de grille,
g) on élimine la couche (14) de protection au moins au-dessus de la zone (9) de source.

2. Procédé suivant la revendication 1,
**caractérisé en ce que** l'on utilise comme couche (4) conductrice une couche de polysilicium.

3. Procédé suivant la revendication 1 ou 2,
**caractérisé en ce que** la couche (14) de protection comprend une couche (14a) d'oxyde de silicium, une couche (14b) de nitrure de silicium, une couche (14c) d'oxyde de silicium.

4. Procédé suivant la revendication 2,
**caractérisé en ce que** l'on utilise une couche (TEOS) comme couche (14a, 14c) d'oxyde de silicium.

5. Procédé suivant l'une des revendications 1 à 4,
**caractérisé en ce que** l'on intègre le transistor DMOS avec des transistors CMOS dans un composant à semiconducteur.

6. Procédé suivant la revendication 5,
**caractérisé en ce que** l'on produit l'oxyde de grille pour les transistors CMOS entre le stade f) et le stade g).

7. Procédé suivant l'une des revendications 5 ou 6,
**caractérisé en ce que** l'on produit les électrodes de grille des transistors CMOS entre le stade f) et le stade g).

8. Procédé suivant l'une des revendications 5 à 7,
**caractérisé en ce que** l'on effectue une attaque pour éliminer les restes (12) des électrodes de grille pour les transistors CMOS au-dessus de la zone (9) de source.
